(19) **Europäisches Patentamt / European Patent Office / Office européen des brevets**

(11) **EP 2 110 862 A1**

(12) **EUROPEAN PATENT APPLICATION**
published in accordance with Art. 153(4) EPC

(43) Date of publication:
**21.10.2009 Bulletin 2009/43**

(51) Int Cl.:
***H01L 31/052*** (2006.01)

(21) Application number: **08710752.0**

(22) Date of filing: **04.02.2008**

(86) International application number:
**PCT/JP2008/051773**

(87) International publication number:
**WO 2008/096711 (14.08.2008 Gazette 2008/33)**

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **06.02.2007 JP 2007026676**
**17.05.2007 JP 2007131730**

(71) Applicant: **Hitachi Chemical Co., Ltd.**
**Shinjuku-ku**
**Tokyo 163-0449 (JP)**

(72) Inventor: **OKANIWA, Kaoru**
**Ibaraki 300-4247 (JP)**

(74) Representative: **HOFFMANN EITLE**
**Patent- und Rechtsanwälte**
**Arabellastrasse 4**
**81925 München (DE)**

(54) **SOLAR CELL MODULE AND WAVELENGTH CONVERSION TYPE LIGHT COLLECTING FILM FOR SOLAR CELL MODULE**

(57)    A photovoltaic (PV) module in which electric power generation efficiency is enhanced by enhancing light utilization rate. A encapsulant (202) is a first layer, a wavelength conversion type light trapping film (300) is a second layer, an antireflection film (104) is a third layer and an n-type layer is a fourth layer. When the refractive indexed of the layers are expressed as first refractive index ($n_1$), second refractive index ($n_2$), third refractive index ($n_3$) and fourth refractive index ($n_4$), the following relation is satisfied; $n_1 \leq n_2 \leq n_3 \leq n_4$. The wavelength conversion type light trapping film (300) of the second layer has one structured surface on the light incident side and has a refractive index of 1.6-2.4. The wavelength conversion type light trapping film is transparent and contains a fluorescent substance.

FIG. 2

EP 2 110 862 A1

**Description**

TECHNICAL FIELD

The present invention relates to a photovoltaic (PV) module and a wavelength conversion type light trapping film for a PV module. More specifically, the present invention relates to a PV module that enhances power generation efficiency by efficiently guiding incident light into a solar cell and converting the light of wavelength regions not conducive to power generation into light of wavelength regions that are conducive to power generation, and a wavelength conversion type light trapping film for the PV module.

PRIOR ART

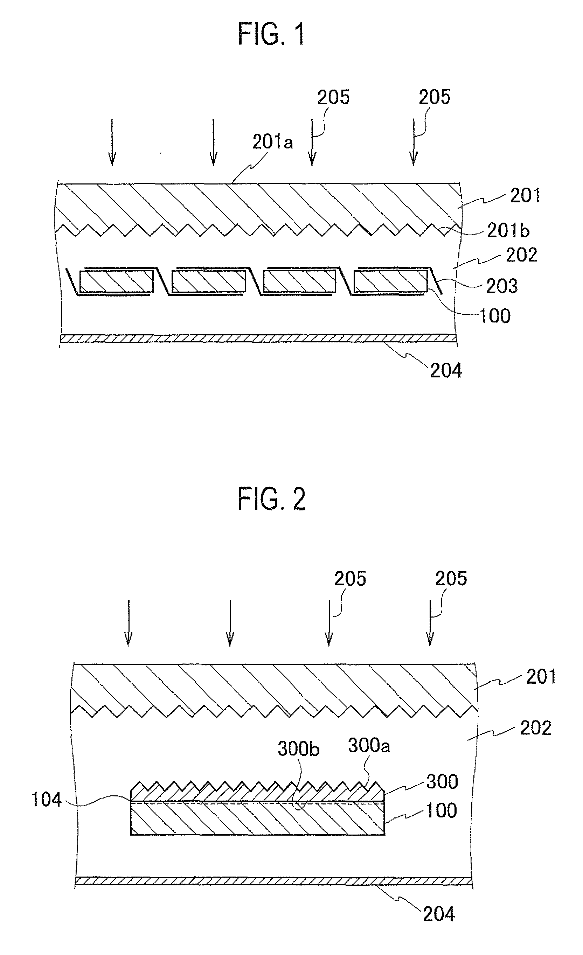

A conventional silicon crystal type PV module is described in cited non-patent document 1 below. A conventional PV module will now be described with reference to the schematic illustration (cross-sectional drawing) of Fig. 1. This conventional PV module comprises a solar cell 100, a cover glass 201, an encapsulant 202, a tab 203 and a back film 204.

Incident light 205 meets the cover glass 201 provided at the incident side. Reinforced Glass, applied with impact absorbent properties can be used for this cover glass 201. In order to facilitate dense adhesion contact with the layered encapsulant 202 the side 201b of the cover glass 201 is embossed to create an uneven shape thereon. This uneven shape is formed on the inner surface, that is to say, on the lower surface of the cover glass 201 in Fig. 1, while the surface 201a of the PV module is smooth.

The encapsulant 202 is generally a resin comprised chiefly of ethylene-vinyl acetate copolymer. The encapsulant 202 encapsulates the solar cell 100. The solar cell 100 converts incident light 205 introduced therein via the cover glass 201 and the encapsulant 202, into electric power. A multicrystal silicon substrate or a single crystal silicon substrate for example, can be used for the solar cell 100. Further, a back film 204 is formed on the side opposite to the aforementioned incident side of the encapsulant 202.

Moreover, in the cited patent document 1 below, a PV module is disclosed that employs a moth-eye configuration, thereby enabling external light from various angles including diagonal angles to be efficiently used without reflection loss, as it is taken in to the PV module. Another configuration in which external light is efficiently taken in without reflection loss is disclosed in cited nonpatent document 2 below, in which a transparent part is formed of a conical shape, a triangular pyramid shape or a quadrangular pyramid.

Further, patent documents 2-14 disclose a variety of configurations for methods in which a layer is disposed on the light receiving side of a solar cell, which layer performs wavelength conversion on light of infrared regions and light of ultraviolet regions that is not conducive to power generation and emits light of wavelength regions that are conducive to power generation.

The inventions proposed in patent documents 2-14 however do not operate as effectively as anticipated because there is difficulty controlling the direction of travel of light emitted from the wavelength conversion (light emitting) layer. That is to say, light subject to wavelength conversion is emitted in a variety of directions such that emitted light of part of the layer structure is not only guided into the cell but travels in the input direction or in the frontal direction of the layer perpendicular to the input direction. This light does not contribute to power generation.

Nonpatent document 1: Yoshihiro Hamakawa "Solar Generation" Latest Technology and Systems, CMC Co. Ltd. 2000.
Nonpatent document 2: Hiroshi Toyota, Antireflection Structured Surface, Optics Volume 32 No. 8, page 489, 2003.
Nonpatent document 3: N. Kamata, D. Terunuma, R. Ishii. H. Satoh, S. Aihara, Y. Yaoita, S. Tonsyo, J. Organometallic Chem., 685, 235, 2003.
Patent document 1: Japanese Patent Application Laid-Open No. 2005-101513
Patent document 2: Japanese Patent Application Laid-Open No. 2000-328053
Patent document 3: Japanese Patent Application Laid-Open No. 1997-230396
Patent document 4: Japanese Patent Application Laid-Open No. 2003-243682
Patent document 5: Japanese Patent Application Laid-Open No. 2003-218379
Patent document 6: Japanese Patent Application Laid-Open No. 1999-345993
Patent document 7: Japanese Patent Application Laid-Open No. 2006-024716
Patent document 8: Examined Patent Application Publication No. 1996-004147
Patent document 9: Japanese Patent Application Laid-Open No. 2001-094128
Patent document 10: Japanese Patent Application Laid-Open No. 2001-352091
Patent document 11: Japanese Patent Application Laid-Open No. 1998-261811
Patent document 12: Japanese Patent No. 2,660,705
Patent document 13: Japanese Patent Application Laid-Open No. 2006-269373

Patent document 14: Japanese Patent Application Laid-Open No. 1988-006881
Patent document 15: Japanese Patent Application Laid-Open No. 2002-225133

DISCLOSURE OF THE INVENTION

In the case of the above described conventional PV modules the problem is that significant difference in the respective refractive indexes of the solar cell 100 and the encapsulant 202 means that light reflection (of the incident light 205) arises at the boundary face, meaning that the light is inefficiently utilized.

Further, with for example a silicon crystal solar cell, solar light that is of wavelengths less than 400 nm and wavelengths longer than 1200 nm is not effectively utilized so that approximately 56% of solar light energy does not contribute to photoelectric conversion due to spectrum mismatch.

With the foregoing in view the object of the present invention is to provide a PV module having improved power generation efficiency and a wavelength conversion type light trapping film for the PV module.

It is a further object of the present invention to provide a PV module that reduces solar light loss due to spectrum mismatch enabling light to be more efficiently utilized, thus providing improved power generation efficiency and a wavelength conversion type light trapping film for the PV module.

In order to solve the above described problems, the PV module related to the present invention provides a PV module that generates electric power in response to incident light having layered members including a plurality of layers with light transmitting properties (light transmitting layers) in which, starting from the side from which incident light enters, this plurality of light transmitting layers comprise a first layer, a second layer,... m-th layer, and the respective refractive indexes of this plurality of light transmitting layers are first refractive index $n_1$, second refractive index $n_2$,... m-th refractive index $n_m$, where $n_1 \leq n_2 \leq .. n_m$, moreover, at least one layer from among the light transmitting layers is a wavelength conversion type light trapping film having a uneven shape on the incident side where the incident light enters, the refractive index of which is 1.6-2.4, and this wavelength conversion type light trapping film includes a fluorescent substance.

In this PV module the value of normalized absorbance a of the light trapping film, as shown in the following mathematical expression (1), should preferably be 0.1 or less when the wavelength of the incident light is 400-1200 nm.

[Mathematical Expression 1]

$$a[- / \mu m] = \frac{-\log_{10}(T)}{L} \quad (1)$$

Here, T is the transmission rate, L is the average thickness ($\mu$m) of the film.

It is preferable that the incident light side in which the incident light enters of the wavelength conversion type light trapping film, has a multiplicity micro protrusions or micro recessions of conical shape or multiangle pyramid shape without interludes therebetween.

Moreover, it is preferable that the fluorescent substance of the wavelength conversion type light trapping film absorbs light of 300-400 nm, emits light of 400-1200 nm and can convert wavelengths.

In other words, the wavelength conversion type light trapping film uses the fluorescent substance and absorbs light of 300-400 nm and emits light of 400-1200 nm. In this way wavelength conversion occurs in the wavelength conversion type light trapping film, such that light of wavelengths 400-1200 nm is guided into the solar cell, where it undergoes photoelectric conversion. This overcomes the problem of spectral mismatch.

Further, the wavelength conversion type light trapping film having an uneven shape thereon, includes a fluorescent substance, and thus, to a greater extent than the structures employed in patent document 1 above and other cited documents, in which refractive index is controlled using light trapping film alone, a structure is provided that enables superior effects through employing wavelength conversion. Moreover, by having the uneven shape formed, the directivity of light is controlled such that both incident light and emitted light can be more efficiently guided to the solar cell.

The PV module according to the present invention reduces solar light loss due to spectral mismatch, and by controlling the travel direction of light, realizes improved light utilization rate and more efficient power generation.

In order to solve the above described problems, the wavelength conversion type light trapping film for the PV module related to the present invention is a wavelength conversion type light trapping film for a PV module that generates electric power in response to incident light having layered members including a plurality of light transmitting layers in which at least one of the layers among the plurality of light transmitting layers extending from the incident light side is used as a wavelength conversion type light trapping film, the incident light side in which incident light enters has a uneven shape thereon, and further, starting from the side from which incident light enters, this plurality of light transmitting layers comprise a first layer, a second layer,... m-th layer, and the respective refractive indexes of this plurality of light transmitting layers are first refractive index $n_1$, second refractive index $n_2$,... m-th refractive index $n_m$, where $n_1 \leq n_2 \leq... n_m$, the refractive index of these layers is 1.6-2.4, and this wavelength conversion type light trapping film includes a fluorescent substance.

Moreover, it is preferable that, as shown in mathematical expression (2), in the wavelength conversion type light trapping film 300, the value of normalized absorbance a is not greater than 0.1 where the wavelength of the incident light is 400-1200 nm.

[Mathematical Expression 2]

$$a[-/ \mu m] = \frac{-\log_{10}(T)}{L} \quad (2)$$

Here, T is the light transmission ratio and L the average thickness of the film ($\mu$m).

Again, it is preferable that the incident light side in which the incident light enters of the wavelength conversion type light trapping film, has formed thereon a multiplicity micro protrusions or micro recessions of conical shape or multiangle pyramid shape without interludes therebetween.

Moreover, it is preferable that the fluorescent substance of the wavelength conversion type light trapping film absorbs light of 300-400 nm, emits light of 400-1200 nm and can convert wavelengths.

In other words, the wavelength conversion type light trapping film uses the fluorescent substance and absorbs light of 300-400 nm and emits light of 400-1200 nm. In this way wavelength conversion occurs in the wavelength conversion type light trapping film, such that light of wavelengths 400-1200 nm is guided into the solar cell, where it undergoes photoelectric conversion. This overcomes the problem of spectral mismatch.

In the PV module according to the present invention the relationship $n_1 \leq n_2 \leq n_m$, arises in the refractive indexes being the first refractive index $n_1$, second refractive index $n_2$,... m-th refractive index $n_m$, of the plurality of light transmitting layers that can be referred to as a first layer, a second layer and m-th layer; at least one layer from among these light transmitting layers has an structured shape formed on the incident light side into which light enters; the refractive index of that one layer is 1.6-2.4; and this wavelength conversion type light trapping film includes a fluorescent substance, thus an improved light utilization rate (power generation efficiency) can be realized in the PV module. Further, solar light loss due to spectral mismatch is reduced bringing improved light utilization rate and greater power generation.

Moreover, in the wavelength conversion type light trapping film for a PV module according to the present invention a florescent substance is used such that light of for example 300-400 nm is absorbed and light of 400-1200 nm is emitted, thus wavelength conversion is performed efficiently. This enables the problem of spectral mismatch to be overcome. That is to say, because the fluorescent substance is included a structure is provided that enables more effective wavelength conversion, to a greater extent than refractive index control by a light trapping film alone as in structures of the conventional art. Further, due to the formation of the fine uneven shapes, the directivity of light is controlled such that both incident light and emitted light can be more efficiently guided to the solar cell.

BRIEF DESCRIPTION OF THE DRAWINGS

Fig. 1 is a cross-sectional drawing of a conventional PV module;
Fig. 2 is a cross-sectional drawing of the best mode for carrying out the PV module according to the present invention;
Fig. 3 shows the configuration of the wavelength conversion type light trapping film 300;
Fig. 4 is a cross-sectional drawing showing the condition in which a mold film is applied over a light trapping film;
Fig. 5 is a cross-sectional drawing showing a configuration in which a PV module has a light trapping film with mold film adhered, disposed over the solar cell; and
Fig. 6 shows the processing sequence for applying the light trapping film to the solar cell.

Brief Description of the Reference Symbols

100   Solar cell
101   p-type silicon substrate
102   Textured structure
103   n-type layer

104  Anti-reflective layer
201  Cover glass
202  Encapsulant
300  Wavelength conversion type light trapping film
301  Mold film
302  Wavelength conversion type light trapping film seating part
303  Wavelength conversion type light trapping film structured shape part
304  PET film
305  High refractive index resin composition layer including a fluorescent substance, in semi-hardened state
306  PP film

BEST MODE FOR CARRYING OUT THE INVENTION

The best mode for carrying out the invention will now be described with reference to the drawings. Fig. 2 is a cross-sectional drawing of a PV module employing a silicon substrate as the material for a solar cell.

This PV module is a module that generates electric power when incident light 205, entering from the incident side by passing a plurality of light transmitting layers including a cover glass 201, encapsulant 202 and wavelength conversion type light trapping film 300, is guided into the solar cell 100. The light transmitting layers in this case indicate the configuration, providing a concrete example of the structure. Another configuration could include for example providing an anti-reflective layer over glass in front of the cover glass 201 at the incident light side. In the case of conventional PV modules however, an anti-reflective layer over glass is not usual, neither is it essential for the present invention.

The wavelength conversion type light trapping film 300 is a film in which uneven shapes are formed on the surface on one side, that is the incident light side into which light enters. The refractive index of this side is 1.6-2.4, it includes a fluorescent substance and is transparent. This surface on one side of the wavelength conversion type light trapping film 300 has formed thereon without interludes therebetween, a multiplicity of micro protrusions or micro recessions, the shape of each of these protrusions or recessions being either conical or a multiangle pyramid each of substantially the same form.

The method for producing the wavelength conversion type light trapping film used in the present invention involves for example, adhering a film in a semihardened state, that can either be optically or thermally hardened over a cell using a vacuum laminator. This film, by being an organic-inorganic hybrid compound including titanium tetra alkoxide and including a fluorescent substance, provides both a high refractive index and wavelength conversion functionality. Further, as the material can be optically or thermally hardened it can be made into a film shape by casting on a base film such as PET or the like. It is then covered using a separator film such as PP or the like.

The wavelength conversion type light trapping film 300 is adhered on the incident light side of the solar cell 100. The solar cell 100 comprises for example a p-type silicon substrate, an n-type layer, an anti-reflective layer, a front surface electrode, a back surface electrode, a p + layer. The wavelength conversion type light trapping film 300 is adhered to the solar cell. The light trapping film 300 is in contact with anti-reflective layer 104 of the solar cell 100.

The solar cell 100 is a silicon crystal arrangement solar cell that employs a multicrystal silicon substrate or single crystal silicon substrate, using for example the p-type silicon substrate of a thickness of a few hundred $\mu$m. An n-type layer is formed uniformly on the surface of the p-type silicon substrate.

The anti-reflective layer 104 prevents unnecessary reflection of incident light efficiently trapped by the light trapping film 300, and employs for this a nitrous silicon film having a refractive index in the range of 1.8-2.7, structured of silicon Si, nitrogen N and hydrogen H. This film should be of a thickness in the range of 70-90 nm. Titanium oxide can be used for the anti-reflective layer 104.

As described above, on one side 300a of the wavelength conversion type light trapping film 300 a multiplicity of conical shapes or multi-angle pyramids of micro protrusions or micro recessions are formed spreading so as to cover the side 300a uniformly. These multi-angle pyramids are each of substantially the same form. The conical shapes also are of substantially the same form. The side 300a is formed on the incident side (where the incident light 205 enters), while the opposite side 300b of the incident side is in contact with the anti-reflective layer 104 of the solar cell 100. As described, it is also suitable to have uneven shapes formed without interlude therebetween on the surface of the solar cell 100 on the other side.

The refractive index $n_3$ of the wavelength conversion type light trapping film 300 is as follows. In order that light from external sources (incident light 205) can be taken in from a variety of different angles while minimizing reflection loss, efficiently guiding light into the solar cell 100, the refractive index for the wavelength conversion type light trapping film 300 should be higher than that of the encapsulant 202, moreover it should be lower than that of the anti-rellective layer 104 over the solar cell 100; thus the refractive index for the wavelength conversion type light trapping film 300 should be in the range of 1.6- 2.2 and more preferably 1.6-2.0.

Aluminum paste for the back surface is formed on the back surface side opposite the above described incident side (front side) of the p-type silicon substrate 101, and the back surface side electrode 108 is formed thereon. Further, a BSF (Back Surface Field) layer 109 is formed by the reaction of the aluminum in the aluminum paste on the back surface side with the silicon on the back surface side to form a p+ layer, providing improved power generating capacity.

For the wavelength conversion type light trapping film 300, in order to facilitate efficient direction of light incident from multiple angles into the solar cell, the finer the apex angle the more effective the structure. However where there is reflection loss at the boundary surface between the light trapping film 300 and the solar cell 100 then if that apex angle is too acute that reflected light may leak outside the structure. In order to enable the reflected light to be reflected again by the light trapping film 300 and smoothly returned into the solar cell 100, the apex angle should ideally be 90°. A 90° apex angle is most suitable in terms of performance and manufacturing precision.

According to cited nonpatent document 2 the size of the baseline is a value obtained by division of the shortest wavelength used by the refractive index of the material. Thus where the refractive index is 2.0, for the PV module it is approximately 175 nm. Obtaining the fine structure required however, is premised on the production method used.

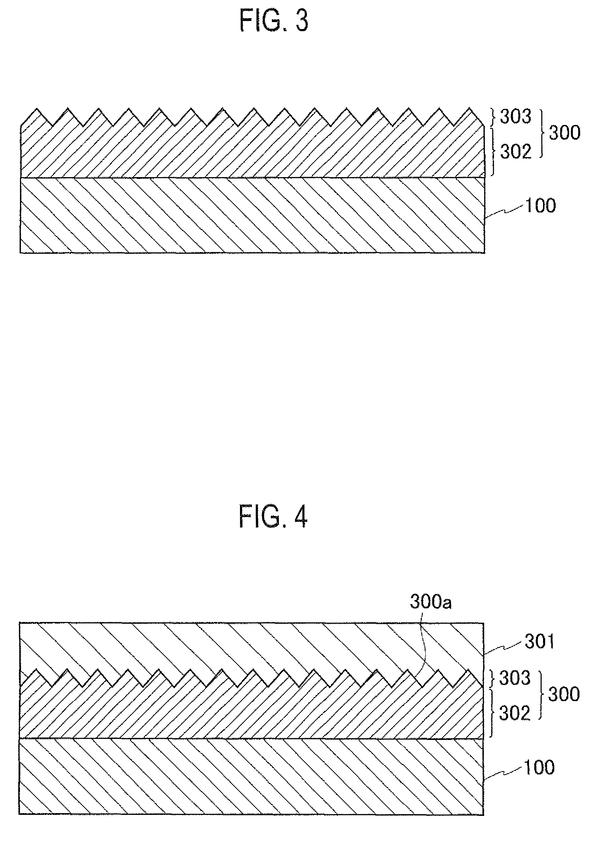

The present invention however does not require this very fine structure. Fig.3 shows the configuration of the wavelength conversion type light trapping film 300. As shown in Fig. 3, the light trapping film 300 employed in the present invention can be considered as divided between the seating part 302 and the structured shaped part 303. The seating part 302 must be spread, embedded following over the uneven form of the solar cell 100, so the thickness cannot exceed that of the uneven shape forms. Normally, a textured structure is applied to the front surface of the solar cell 100, the depths of which is 0 -20 $\mu$m. On the other hand, the height of the multiplicity of micro protrusions and recessions, essentially a part of the light trapping film 300, formed so as to spread with regularity and without gaps on the light trapping film 300, should, due chiefly to the requirements of the production process, be 1-100 $\mu$m.

The wavelength conversion type light trapping film having a refractive index of 1.6-2.4, follows the uneven form of the cell as described above. Because the fine uneven form of the light trapping film original must be transferred, it is important to be of a resin compound material in a semi-hardened state. In the present invention an organic-inorganic hybrid composite material including titanium tetra alkoxide provides the wavelength conversion type light trapping film 300, realizing the high refractive index and enabling ready form transference, while a fluorescent substance must be included to facilitate wavelength conversion.

That is to say, in a semi-hardened state, the wavelength conversion type light trapping film 300 is vacuum laminated onto the solar cell 100, or, is painted on as a varnish of for example polymer, monomer, an initiator and solvent and the like, and dried with a solvent. At this point the wavelength conversion type light trapping film 300 is perfectly spread, embedded to cover the uneven form of the cell.

If the wavelength conversion type light trapping film 300 is originally of a film form, the separator film is peeled off and a mold film with the fine uneven form of the wavelength conversion type light trapping film original is again vacuum laminated as the form is transferred

The multiplicity of conical shapes or multi-angle pyramids of micro protrusions or micro recessions of the wavelength conversion type light trapping film 300 are formed using a mold film. Briefly, a mold film formed spread with multiple micro protrusions or recessions uniformly and without intervals therebetween is laid over the wavelength conversion type light trapping film 300, before a vacuum lamination process is once again employed in a feature replication process. Thereafter the mold film is peeled off and the wavelength conversion type light trapping film 300 is hardened through UV irradiation. It is also suitable to layer the mold film on the wavelength conversion type light trapping film 300 without removing it.

The mold film used to form the arrangement of multiple micro protrusions and recessions spread over the wavelength conversion type light trapping film 300 without interludes therebetween will now be described in detail. Fig. 4 shows the condition in which a mold film 301 is laid over the wavelength conversion type light trapping film 300. The mold film 301 is a film having formed thereon a multiplicity of micro protrusions or recessions with no interludes between them, that join so as to perfectly complement the protrusions or recessions formed on the side 300a of the wavelength conversion type light trapping film 300 by biting together perfectly with no gaps, thus providing a casting of the recessions or protrusions of the wavelength conversion type light trapping film 300.

The manufacturing procedures consist of laying the wavelength conversion type light trapping film 300 over the mold film 301 then using vacuum lamination to replicate the features. Next, the mold film 301 is peeled off and the wavelength conversion type light trapping film 300 hardened by irradiation with UV light

Referring to Fig. 2, the mold film 301 has been taken off, giving a structure of layered encapsulant 202. Here, the uneven shape of the wavelength conversion type light trapping film 300 is in a well filled condition without gaps so that gaps do not arise.

It is also possible however to dispense with the removal of the mold film 301 and to employ the light trapping film with mold film applied, in the condition layered on the wavelength conversion type light trapping film 300.

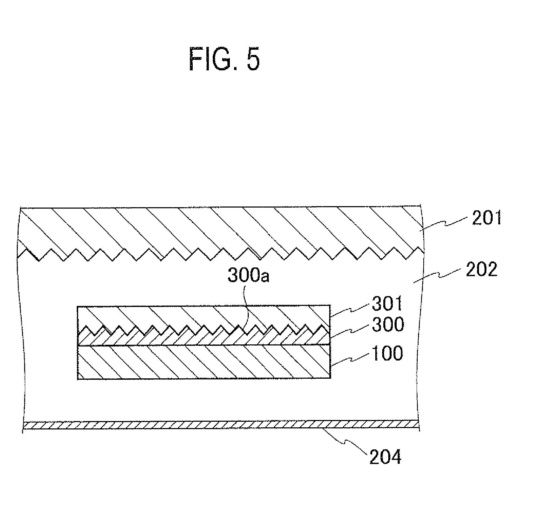

Fig. 5 is a structural drawing showing a configuration in which a PV module has a wavelength conversion type light trapping film 300 with adhered mold film 301 applied, disposed over the solar cell 100. The wavelength conversion type light trapping film 300 side is layered on the side of the solar cell 100. One surface of the wavelength conversion type light trapping film 300 traces, with no gap therebetween, the uneven shape on the front surface of the solar cell, and is adhered joining over the solar cell 100, layered as it is without removing the mold film 301 used for the protrusions or recessions, on the other surface 300a of the wavelength conversion type light trapping film 300. The external view provides a smooth appearance of light trapping film with mold film applied. The mold film 301 used here has formed thereon without interludes therebetween, a multiplicity of micro protrusions and recessions that join (biting perfectly together with no gaps) complementing the micro protrusions and recessions on the side 300a with micro protrusions and recessions of the wavelength conversion type light trapping film 300, moreover, the refractive index of the mold film 301 is smaller than the refractive index $n_2$ of 300.

When the varnish material is used for the wavelength conversion type light trapping film 300, the varnish is painted over the solar cell and after drying the solvent, the form is transferred using the mold film. At this point it is suitable for the mold film 301 to be peeled off or to remain applied when the hardening process is performed.

The method for hardening the resin composition may involve making the resin composition originally able to submit photo hardening processes or thermal hardening processes.

The PV module shown in Fig. 2 employing the solar cell 100 has for example the encapsulant 202 as a first layer (the refractive indexes of the cover glass 201 and the encapsulant 202 are considered optically equivalent), the wavelength conversion type light trapping film 300 as a second layer, the anti-reflective layer 104 as a third layer and the n-type layer 103 as a fourth layer; and when the refractive indexes of the layers are expressed as first refractive index $n_1$, second refractive index $n_2$, third refractive index $n_3$ and a fourth refractive index $n_4$, the relationship $n_1 \leq n_2 \leq n_3 \leq n_4$ is satisfied. The wavelength conversion type light trapping film 300 comprising the second layer, that is one layer among the light transmitting layers, has an uneven shape thereon as described above, on the incident side 300a where the incident light 205 enters. Specifically, the light trapping film 300 is formed having a multiplicity conical shapes or multi-angle pyramids of micro protrusions or micro recessions spreading so as to cover it uniformly. Further, as noted above, the refractive index $n_3$ of the wavelength conversion type light trapping film 300 is 1.6-2.4.

Moreover, in the light trapping film 300, as shown in mathematical expression (3), the value of normalized absorbance a is not greater than 0.1 where the wavelength of the incident light is 400-1200 nm.

[Mathematical Expression 3]

$$a[-/\mu m] = \frac{-\log_{10}(T)}{L} \quad (3)$$

Here, T is the light transmission ratio and L the average thickness of the film ($\mu$m).

Production of the PV module shown in Fig. 2 will now be described. Ideally, the distribution of the refractive indexes of the respective layers should be such that the refractive index becomes continually higher moving from the shallower layers ("shallower" here meaning the smaller numbers among first, second ... m-th numbers from the incident side). However, the anti-reflective layer 104 comprising the third layer and the n-type layer 103 comprising the fourth layer are formed at the cell formation process for forming the solar cell 100. The layers shallower than these, the cover glass 201, the encapsulant 202 and the light trapping film 300 (first and second layers) are formed at the module formation stage. For this reason, it has been difficult in the case of conventional technology to achieve a sequential refractive index distribution straddling each layer member.

In the present invention the refractive indexes of the anti-rellective layer 104 formed during the cell formation process and the light trapping film 300 formed during the module formation process are adjusted to obtain the optimum mutual balance. Basically, the refractive index $n_2$ of the light trapping film 300 is made lower than the refractive index $n_3$ of the anti-reflective layer 104. While if in the module formation process the refractive index $n_1$ of the encapsulant 202 (first layer) is made lower than the refractive index $n_2$ of the light trapping film 300 (second layer) the above expression $n_1 \leq n_2 \leq n_3 \leq n_4$ is realized.

In terms of physical configuration, the moth-eye structure is what realizes continually even refractive indexes. However, as is evident by reference to non-patent document 2 the fine pyramid form required there determines what order of light is guided into the module. In contrast to this, in the case of the present invention such a fine form is not required, while forms of not less than 10 $\mu$m that can be applied using ordinary molds can be used. This is because rather than requiring a continuous even refractive index distribution, the present invention uses optical paths and multiple reflection understood by reference to geometrical optics.

In this way, the present invention reduces reflection loss occurring in encapsulant cell boundary faces in conventional technology, optical boundary faces resulting from module layer construction demanded by the production processes being employed, and enables a greater quantity of light to be introduced into the solar cell 100. Accordingly, the most important point about the present invention is that it provides a configuration that enables light to be more efficiently guided into the pn connecting part of the solar cell 100 as the light trapping film 300 has a higher refractive index than the encapsulant 202. Basically, the efficiency by which light is guided by the light trapping film 300 is maximized by adjusting the respective refractive indexes of the light trapping film 300 and the anti-reflective layer 104 over the solar cell 100.

Explained in other terms, a point about the present invention is that the structure optimizes refractive indexes by adjusting the refractive indexes of the light trapping film 300 and the anti-reflectivc layer 104 of the solar cell 100. For example it is not easy to change the refractive index of the cover glass 201 providing the outermost layer (incident side), of the encapsulant 202 comprising the next layer under, or of the n-type layer inside the solar cell or of the p-type silicon layer for example. The fact however that the refractive indexes of the light trapping film 300 and the anti-reflective layer 104 comprising the intermediate layers can be adjusted, means that the above described relationship $n_1 \leq n_2 \leq n_3 \leq n_4$ can be readily realized.

In more simple terms, because the refractive indexes of the cover glass 201 and the encapsulant 202 are substantially equivalent these can be considered as optically equivalent (refractive index $n_1$). Further, when there is refractive index $n_2$ of the light trapping film 300, refractive index $n_3$ of the anti-reflective layer 104 and the refractive index $n_4$ of the n-type layer 103, the following mathematical expression is desirable.

$$n_2 = \sqrt{(n_1 \, n_3)}$$

$$n_3 = \sqrt{(n_2 \, n_4)}$$

With concrete values inserted, we get $n_1 \approx 1.5$, $n_4 \approx 3.4$ calculated to give $n_2 \approx 1.97$, $n_3 \approx 2.59$.

The wavelength conversion type light trapping film 300 must include a fluorescent substance to facilitate wavelength conversion. This fluorescent substance is described subsequently.

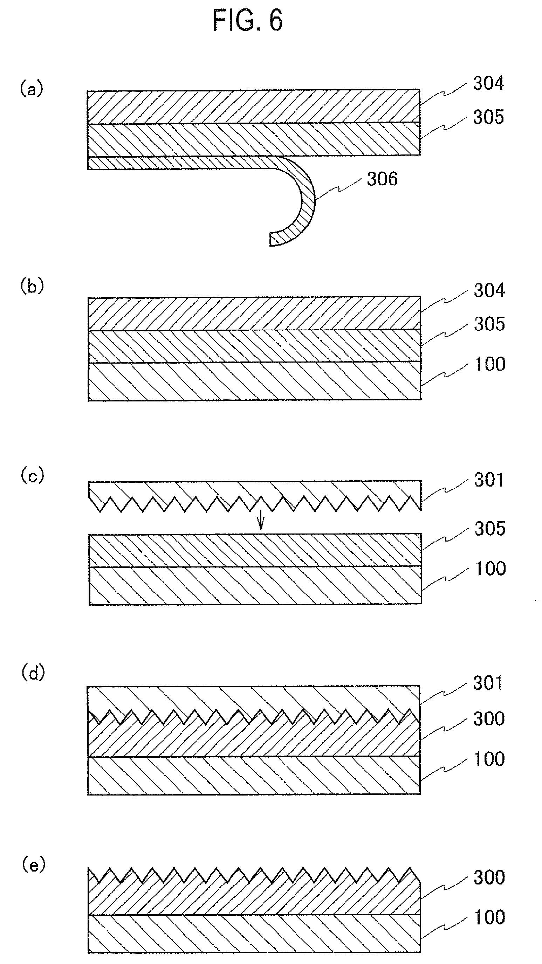

The procedures for applying the wavelength conversion type light trapping film 300 to the solar cell 100 will now be described in detail. Fig. 6 shows the processing sequence for applying the wavelength conversion type light trapping film 300 to the solar cell 100. A semi hardened state, high refractive index, resin compound 305 that includes a fluorescent substance, is used for the wavelength conversion type light trapping film 300.

This semi-hardened state, high refractive index, fluorescent substance containing, resin compound 305, is of an organic-inorganic hybrid material including titanium tetra alkoxide, that can provide the high refractive index, is able to submit photo hardening and has a fluorescent substance. As shown in Fig. 6a the high refractive index, fluorescent substance containing, resin compound 305 is sandwiched between the PET film 304 and PP film (separator film) 306. Basically, the manufacturing process involves producing a film applied on a substrate PET film 304 of PET or the like, which is then covered by a separator film 306 of PP or the like.

Then, as shown in Fig. 6b, at the lamination stage of the solar cell 100, after the separator film 306 of PP or the like is peeled off, the arrangement of the semi-hardened state, high refractive index, fluorescent substance containing, resin compound 305 and the PET film 304 is placed on the solar cell 100, before vacuum lamination is performed.

As shown in Fig. 6c and Fig. 6d, the mold film 301 formed having a multiplicity of micro protrusions and recessions so as to spread with regularity and without gaps arising, is then placed over the semi-hardened state, high refractive index, resin compound 305 containing a fluorescent substance, before vacuum lamination is used once more to transfer the form.

The mold film 301 is then peeled off and the fluorescent substance containing, wavelength conversion type light trapping film 300 is hardened by irradiation with UV. In this way, when the form transference process is complete, the semi-hardened state, high refractive index, resin compound 305 can be hardened either by an phto or thermal hardening process. It is suitable for the mold film 301 to remain in this condition on the wavelength conversion type light trapping film 300, and it can be sandwiched between the cover glass 201, the encapsulant 202 and the back film 204 as the module is formed.

Fig. 6e shows the condition in which the mold film 301 has been peeled off, after the condition shown in Fig. 6d. After the mold film 301 is removed the module can be formed by sandwiching the arrangement between the cover glass 201, the encapsulant 202 and the back film 204.

At this time, where the cell textured structure is a depth of 10 $\mu$m and the depth of the uneven shape of the mold film is made 10 $\mu$m, the light trapping film (semi hardened state, high refractive index film) prior to lamination must be at least 20 $\mu$m thick. The seating part 302 of the wavelength conversion type light trapping film 300 should be 10 $\mu$m thick, and the structured shaped part 303, 10 $\mu$m thick. For the present invention, there is no active formation of a textured structure, but as at the stage of slicing from a silicon ingot an uneven shape is left slightly on the surface, the dimensions of the seating part 302 must correspond to those of the uneven shape.

The organic-inorganic hybrid material for the semi-hardened state, high refractive index, resin compound 305 used as the wavelength conversion type light trapping film 300 will now be described.

In order to obtain the high refractive index in the present invention the sol-gel method is employed for the organic-inorganic hybrid material. The required composite for application of the sol-gel method here is a metal alkoxide expressed as

$$(R^1)_n M - (OR^2)_m$$

In the present invention at least some of what is used is titanium tetra alkoxide expressed

$$Ti-(OR)_4.$$

A metal that complements this allows M to be selected from among Zn, Al, Si, Sb, Be, Cd, Cr, Sn, Cu, Ga, Mn, Fe, Mo, V, W, and Ce. For the R, the $R^1$ and $R^2$ of carbon numbers 1-10 have multiple bondings with M, but it is suitable for each to be the same or of different material. n is an integer not less than 0, and m an integer not less than 1 so n+m is equivalent to the valance of M. The metallic alkoxide used in order to obtain the organic-inorganic hybrid material by the sol-gel method may be just one type or a multiplicity.

In order to obtain the organic-inorganic hybrid material using the sol-gel method a metal alkoxide, water and an acid (or alkali) catalyst are added to a resin compound solution. This is then painted onto a substrate, a solvent is then splattered on and the whole is heated. Depending on the reactivity of the metal alkoxide selected however water and/or an acid (or alkali) catalyst may or may not be required. Further, the temperature of heating applied depends on the reactivity of the metal alkoxide. In the case of a highly reactive metal alkoxide like Ti or the like, a catalyst is not required, and the heating temperature can be 100°C. For the present invention, a three dimensional structure (-M-O-) is not required and providing the high refractive index is sufficient. Especially in the case of titanium oxide, the three-dimensional structure is a semiconductor as used for a photo-catalyst produces. However, the structure is susceptible to photo-degradation and the three-dimensional structure may even break, thus it is effective to have another metallic alkoxide used in conjunction.

The mold film 301 (the mold film providing the casting for the uneven shape of the light trapping film) can be produced using the method disclosed in Japanese Patent Application Laid-Open No. 2002-225133.

A rare earth element gas or an ion or the organometallic complex thereof, can be used for the fluorescent substance used in the present invention. In the case of an ion, this can be introduced in an inorganic host crystal as an activator agent. In the case of the organometallic complex, the material can be dispersed as it is in the high refractive index resin compound.

The rare earth element could be for example, Ce (cerium), Pr (praseodymium), Nd (neodymium), Pm (promethium), Sm (samarium), Eu (europium), Gd (gadolinium), Tb (terbium), Dy (dysprosium), Ho (holmium), Er (erbium), Tm (thulium), Yb (ytterbium).

Further, it is suitable to use for the fluorescent substance of the present invention, an element called an ns2 ion as the emission center activated in a crystalline matrix. It is also possible to use a metallic oxide or substance of the organometallic complex of these. This could include for example Cu (copper), Zn (zinc), Ga (gallium), Ge (germanium), As (arsenic), Ag (silver), Cd (cadmium), In (indium), Sn (tin), Sb (antimony), Au (gold), Hg (mercury), Ti (thallium), Pb (lead), Bi (bismuth).

Moreover, it is suitable to use for the fluorescent substance of the present invention an element called a transition metal ion as the emission center activated in a crystalline matrix. A metallic oxide or substance of the organometallic complex of these is also suitable. These could include for example Cr (chrome), Fe (iron), Mn (manganese).

Again, it is suitable to use for the fluorescent substance of the present invention an organic florescent substance. These could include for example fluoranthene, perylene, acridine orange, rhodamine 6G, rhodamine B, Brilliant Sulfaflavine FF, basic yellowHG, eosine or the like.

The present invention is not limited to usage of these fluorescent substances only, rather, the substance should be selected to suit the objective. For example with the silicon crystal solar cells solar light of wavelengths shorter than 400 nm and wavelengths longer than 120 nm is not used effectively, therefore it is suitable for wavelengths shorter than 400 nm to be absorbed and for light emission to be 400-1200 nm. An example of this kind of florescent substance is Eu (TTA)3phen proposed in nonpatent document 3.

In the case of amorphous silicon solar cells, GaAs solar cells, CIS solar cells, PbS solar cells or CdS solar cells, the fluorescent substance used should be selected according to the sensitivity spectral.

An embodiment of the present invention will now be described with reference to the drawing.

EMBODIMENT

Adhere the wavelength conversion type light trapping film 300 over a solar cell using the method described above.

Fig. 2 is a schematic drawing showing the wavelength conversion type light trapping film 300 adhered on the solar cell, incorporated into a module, in the case where the mold film 301. is not remaining in the PV module. In Fig. 2 however, the connecting tab has been omitted.

Fig. 5 shows the structure of the PV module with the light trapping film with adhered mold film applied, disposed over the solar cell. In other words the configuration in which the mold film 301 remains in the PV module. In Fig. 5 however, the connecting tab has been omitted.

**Claims**

1. A photo-voltaic (PV) module that generates electric power in response to incident light having layered members including a plurality of light transmitting layers, **characterized in that**
starting from the side from which incident light enters, the plurality of light transmitting layers comprise a first layer, a second layer,... m-th layer, and the respective refractive indexes of this plurality of light transmitting layers are first refractive index $n_1$, second refractive index $n_2$,.. m-th refractive index $n_m$, where $n_1 \leq n_2 \leq ... n_m$, at least one layer from among the light transmitting layers is a wavelength conversion type light trapping film having an structured shape on the incident side where the incident light enters, the refractive index of which is 1.6-2.4, this wavelength conversion type light trapping film including a fluorescent substance.

2. The PV module according to claim 1 wherein the value of normalized absorbance a of the wavelength conversion type light trapping film, as shown in the following mathematical expression (4), should preferably be 0.1 or less when the wavelength of the incident light is 400-1200 nm

[Mathematical Expression 4]

$$a\left[-/\mu m\right] = \frac{-\log_{10}(T)}{L} \quad (4)$$

wherein T is the transmission rate, L is the average thickness ($\mu$m) of the film.

3. The PV module according to claim 1 wherein the wavelength conversion type light trapping film has formed on the incident light side in which the incident light enters, a multiplicity of micro protrusions or micro recessions of conical shape or multiangle pyramid shape without interludes therebetween.

4. The PV module according to any of claims 1 through 3 wherein the fluorescent substance of the wavelength conversion type light trapping film absorbs light of 300-400 nm, emits light of 400-1200 nm and can convert wavelengths.

5. A wavelength conversion type light trapping film for a photovoltaic (PV) module that generates electric power in response to incident light having layered members including a plurality of light transmitting layers, **characterized in that**
at least one of the layers among the plurality of light transmitting layers extending from the incident light side is used as a wavelength conversion type light trapping film; and
the incident light side in which incident light enters has an structured shape thereon, starting from the side from which incident light enters, this plurality of light transmitting layers comprise a first layer, a second layer,... m-th layer, and the respective refractive indexes of this plurality of light transmitting layers are first refractive index $n_1$, second refractive index $n_2$,... m-th refractive index $n_m$, where $n_1 \leq n_2 \leq ... n_m$, the refractive index of these layers is 1.6-2.4, and this wavelength conversion type light collecting film includes a fluorescent substance.

6. The wavelength conversion type light trapping film for a PV module according to claim 5 wherein, as shown in mathematical expression (5), the value of normalized absorbance a is not greater than 0.1 where the wavelength of the incident light is 400-1200 nm,

[Mathematical Expression 5]

$$a[-/\mu m] = \frac{-\log_{10}(T)}{L} \quad (5)$$

wherein T is the transmission rate, L is the average thickness ($\mu$m) of the film.

**7.** The wavelength conversion type light trapping film for a PV module according to claim 5 wherein the incident light side in which the incident light has formed thereon a multiplicity of micro protrusions or micro recessions of conical shape or multiangle pyramid shape without interludes therebetween.

**8.** The wavelength conversion type light trapping film for a PV module according to any of claims 5 through 7, wherein the fluorescent substance absorbs light of 300-400 nm, emits light of 400-1200 nm and can convert wavelengths.

## FIG. 1

## FIG. 2

# FIG. 3

# FIG. 4

FIG. 5

# FIG. 6

(a)

304
305
306

(b)

304
305
100

(c)

301
305
100

(d)

301
300
100

(e)

300
100

**INTERNATIONAL SEARCH REPORT**

| International application No. |
|---|
| PCT/JP2008/051773 |

A. CLASSIFICATION OF SUBJECT MATTER
*H01L31/052*(2006.01)i

According to International Patent Classification (IPC) or to both national classification and IPC

B. FIELDS SEARCHED

Minimum documentation searched (classification system followed by classification symbols)
H01L31/052

Documentation searched other than minimum documentation to the extent that such documents are included in the fields searched
| Jitsuyo Shinan Koho | 1922-1996 | Jitsuyo Shinan Toroku Koho | 1996-2008 |
| Kokai Jitsuyo Shinan Koho | 1971-2008 | Toroku Jitsuyo Shinan Koho | 1994-2008 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2005-101513 A (Hitachi Kasei Kabushiki Kaisha), 14 April, 2005 (14.04.05), Full text; all drawings & JP 2005-99693 A & JP 2005-101519 A | 1-8 |
| Y | JP 57-152171 A (Teijin Ltd.), 20 September, 1982 (20.09.82), Page 1, right column, line 15 to page 2, upper left column, line 1 (Family: none) | 1-8 |

| ☒ Further documents are listed in the continuation of Box C. | ☐ See patent family annex. |
|---|---|

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 15 February, 2008 (15.02.08) | 04 March, 2008 (04.03.08) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

| International application No. |
| --- |
| PCT/JP2008/051773 |

C (Continuation).  DOCUMENTS CONSIDERED TO BE RELEVANT

| Category* | Citation of document, with indication, where appropriate, of the relevant passages | Relevant to claim No. |
| --- | --- | --- |
| Y | JP 56-100484 A  (International Business Machines Corp.),<br>12 August, 1981 (12.08.81),<br>Page 1, right column, lines 9 to 16<br>& US 4329534 A          & EP 31494 A1<br>& DE 3065402 D1          & IT 1149264 B | 1-8 |
| Y | JP 7-142752 A  (Nikon Corp.),<br>02 June, 1995 (02.06.95),<br>Par. Nos. [0012] to [0013]; Fig. 1<br>(Family: none) | 1-8 |
| Y | JP 63-200576 A  (Hitachi, Ltd.),<br>18 August, 1988 (18.08.88),<br>Claims<br>(Family: none) | 1-8 |

Form PCT/ISA/210 (continuation of second sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005101513 A
- JP 2000328053 A
- JP 9230396 A
- JP 2003243682 A
- JP 2003218379 A
- JP 11345993 A
- JP 2006024716 A
- JP 8004147 A
- JP 2001094128 A
- JP 2001352091 A
- JP 10261811 A
- JP 2660705 B
- JP 2006269373 A
- JP 63006881 A
- JP 2002225133 A

**Non-patent literature cited in the description**

- Solar Generation. **Yoshihiro Hamakawa.** Latest Technology and Systems. CMC Co. Ltd, 2000
- **Hiroshi Toyota.** *Antireflection Structured Surface, Optics,* 2003, vol. 32 (8), 489
- **N. Kamata ; D. Terunuma ; R. Ishii ; H. Satoh ; S. Aihara ; Y. Yaoita ; S. Tonsyo.** *J. Organometallic Chem.,* 2003, vol. 685, 235